# EUROPEAN PATENT APPLICATION

(11) **EP 4 629 773 A1**
(43) Date of publication of application: **08.10.2025**
(21) Application number: 25157171.7
(22) Date of filing: 11.02.2025
(51) Int. Cl.: H10D 30/01, H10D 30/66, H10D 62/10, H10D 64/00

(54) **TRENCH DEVICE TERMINAL STRUCTURE CONFIGURED TO IMPROVE ELECTRIC FIELD DISTRIBUTION UNIFORMITY AND MANUFACTURING METHOD THEREOF**

(30) Priority: 26.03.2024 CN 202410358807
(71) Applicant: Chongqing Alpha and Omega Semiconductor Limited, Chongqing 400700 (CN)
(72) Inventor: ZHOU, ZHENQIANG, Chongqing, 400700 (CN)
(74) Representative: Metida

(57) **Abstract**

A trench device terminal structure configured to improve electric field distribution uniformity and a manufacturing method thereof are provided. The trench device terminal structure includes terminal trench rings disposed on an epitaxial layer (110) and common trenches (300). Two ends of each of the common trenches (300) are respectively connected to first terminal trenches (231) of an inner terminal ring (230) through first narrow trenches (310). Two ends of each of second terminal trenches (212, 222, 232) are respectively connected to corresponding first terminal trenches (211, 221, 231) through second narrow trenches (320). Two ends of each of the first terminal trenches (211, 221) are respectively connected to the two second terminal trenches (222, 232) of an outer one of the terminal trench rings. By configuring the first narrow trenches (310), an electric field distribution in regions of the trench device terminal structure is made more consistent.

## Description

### TECHNICAL FIELD

The present disclosure relates to a field of power semiconductor devices, and in particular to a trench device terminal structure configured to improve electric field distribution uniformity and a manufacturing method thereof

### BACKGROUND

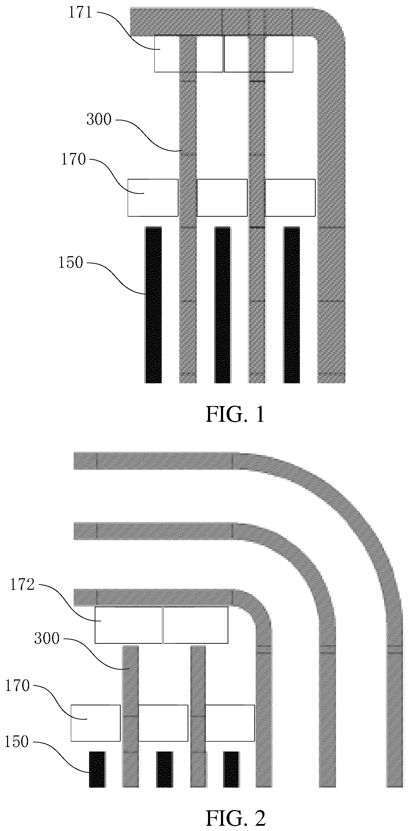

As shown in FIGS. 1 and 2, there are two common terminal structures of trench devices such as a common trench metal-oxide-semiconductor field-effect transistor (MOS) and a split-gate trench (SGT) MOS. Specifically, a terminal structure shown in FIG. 1 is commonly used in in trench devices with a withstand voltage not greater than30V, and a terminal structure shown in FIG. 2 is commonly used in trench devices with a withstand voltage between 30-150V. However, the two terminal structures have some disadvantages that cannot be ignored.

The terminal structure shown in FIG. 1 is only applicable to a condition of high epitaxial concentration (i.e., a doping concentration of an epitaxial layer thereof is at least 10% greater than a reference concentration). If the epitaxial concentration is low (i.e., the doping concentration of the epitaxial layer is at least 10% less than the reference concentration), in a reverse bias state, junction electric fields of T-shaped region 171s (i.e., regions where trenches intersect vertically) of a terminal region of the terminal structure drops to a relatively low level compared to a cell region, while electric fields at bottom portions of the trenches of the terminal structure rise to a relatively high level. As a result, an avalanche voltage of the T-shaped regions 171 is significantly less than that of the cell region, which is prone to application failures and reliability test failures.

The terminal structure shown in FIG. 2 is only applicable to a condition of low epitaxial concentration. If the epitaxial concentration is high, in the reverse bias state, an epitaxial depletion width of each of T-shaped regions 172 shown in FIG. 2 is significantly less than that of an ordinary mesa region 170, and an electric field peak is high and a withstand voltage is low, which is also prone to the application failures and the reliability test failures. In order to solve the problem, the T-shaped regions 172 in the terminal structure are made narrower. However, a width of each of the T-shaped regions 172 has an upper limit and is limited by a trench process, so the terminal structure is not suitable for the trench devices with the withstand voltage not greater than 30V and other medium and low voltage trench devices with low RSP. In addition, ends of the trenches below the T-shaped regions 172 in the terminal structure are regions of concentrated electric fields, which is prone to cause low reliability.

### SUMMARY

In view of defects in the prior art, the present disclosure provides a trench device terminal structure configured to improve electric field distribution uniformity and a manufacturing method thereof.

The present disclosure provides the trench device terminal structure configured to improve the electric field distribution uniformity. The trench device terminal structure comprises a substrate. An epitaxial layer is disposed on the substrate. Terminal trench rings are defined in the epitaxial layer. The terminal trench rings comprise an outer terminal ring, an inner terminal ring, and at least one intermediate terminal ring. The at least one intermediate terminal ring is disposed between the outer terminal ring and the inner terminal ring. Each of the terminal trench rings comprises two first terminal trenches disposed in parallel and two second terminal trenches disposed in parallel. The two second terminal trenches thereof are disposed between the two first terminal trenches thereof.

Common trenches disposed at intervals are disposed in the inner terminal ring. Two ends of each of the common trenches are respectively connected to the two first terminal trenches of the inner terminal ring through first narrow trenches. Two ends of each of the second terminal trenches are respectively connected to corresponding two first terminal trenches through second narrow trenches. Two ends of each of the first terminal trenches of the inner terminal ring are respectively connected to the two second terminal trenches of an adjacent intermediate terminal ring of the at least one intermediate terminal ring by corresponding third narrow trenches. Two ends of each of the first terminal trenches of the at least one intermediate terminal ring are respectively connected to the second terminal trench of an adjacent outer one of the terminal trench rings by corresponding third narrow trenches. A width of each of the first narrow trenches, a width of each of the second narrow trenches, and a width of each of the third narrow trenches are less than a width of each of the first terminal trenches.

The present disclosure further provides a manufacturing method of the trench device terminal structure configured to improve the electric field distribution uniformity. The manufacturing method comprises steps S1-S9.

The step S1 comprises providing the substrate having the epitaxial layer.

The step S2 comprises etching on the epitaxial layer to form the first terminal trenches, the second terminal trenches, the common trenches, the first narrow trenches, the second narrow trenches, and the third narrow trenches.

The step S3 comprises growing first oxide layers in the first terminal trenches, the second terminal trenches, the common trenches, the first narrow trenches, the second narrow trenches, and the third narrow trenches, so as to form the isolation oxide layers in the trench walls of the first terminal trenches, the trench walls of the second terminal trenches, the trench walls of the common trenches and in the first narrow trenches, the second narrow trenches, and the third narrow trenches.

The step S4 comprises depositing polysilicon in the first terminal trenches, the second terminal trenches, and the common trenches to form the source polysilicon structures.

The step S5 comprises etching the source polysilicon structures, ) and the isolation oxide layers on upper portions of the common trenches, growing second oxide layers thereon and etching the second oxide layers to form filling oxide layers, so as to form shallow trenches at the upper portions of the common trenches.

The step S6 comprises growing third oxide layers in the shallow trenches to form gate oxide layers, and depositing the polysilicon in the shallow trenches to form the gate polysilicon structures.

The step S7 comprises forming the body region on the upper portion of the epitaxial layer by injection, and forming, by the injection, source regions between each two adjacent common trenches and the upper portions of the body region.

The step S8 comprises forming the dielectric layer on an upper surface of the epitaxial layer, and respectively forming the contact holes between each two adjacent common trenches and between each of the second terminal trenches of the inner terminal ring and the adjacent common trench; wherein the contact holes penetrate through the dielectric layer and the source regions and extend into the body region.

The step S9 comprises forming the metal layer in the upper surface of the dielectric layer and the contact holes.

In the present disclosure, by configuring the first narrow trenches at connection positions of the common trenches and the terminal trench rings, an electric field distribution in regions of the trench device terminal structure is made more consistent, application performance and reliability of the trench device terminal structure under harsh working conditions are improved, and an epitaxial process window of the trench device terminal structure is increased, thereby reducing a difficulty of process development and debugging.

By configuring the second narrow trenches and the third narrow trenches in corner regions of the terminal trench rings, the trench device terminal structure is allowed to have a larger epitaxial process window. Further, it is easier for trench devices with a withstand voltage of 25-40V to share a same group of masks, so that loss of an RSP level is significantly less than that in the prior art.

### BRIEF DESCRIPTION OF DRAWINGS

The drawings described herein are used to provide further understanding of the present disclosure and constitute a part of the present disclosure. The illustrative embodiments of the present disclosure and descriptions thereof are used to explain the present disclosure and do not constitute improper limitations on the present disclosure.
FIG. 1 is a schematic diagram of a terminal structure of a trench device in the prior art.
FIG. 2 is a schematic diagram of another terminal structure of the trench device in the prior art.
FIG. 3 is a schematic diagram of a trench device terminal structure configured to improve electric field distribution uniformity according to one embodiment of the present disclosure.
FIG. 4 is a cross-sectional schematic diagram of the trench device terminal structure taken along a line A-A shown in FIG. 3.
FIG. 5 is a cross-sectional schematic diagram of the trench device terminal structure taken along a line B-B shown in FIG. 3.
FIG. 6 is a cross-sectional schematic diagram of the trench device terminal structure taken along a line C-C shown in FIG. 3.
FIG. 7 is a flow chart of a manufacturing method of the trench device terminal structure configured to improve electric field distribution uniformity according to one embodiment of the present disclosure.
FIG. 8 is a cross-sectional schematic diagram of common trenches formed by etching in an epitaxial layer.
FIG. 9 is a cross-sectional schematic diagram of first narrow trenches formed by etching in the epitaxial layer.
FIG. 10 is a cross-sectional schematic diagram of isolation oxide layers grown in the common trenches.
FIG. 11 is a cross-sectional schematic diagram of filling oxide layers grown in the common trenches.
FIG. 12 is a cross-sectional schematic diagram of polysilicon depositing in the common trenches.
FIG. 13 is a cross-sectional schematic diagram after the polysilicon etched in the common trenches.
FIG. 14 is a cross-sectional schematic diagram of gate oxide layers grown in shallow trenches.
FIG. 15 is a cross-sectional schematic diagram of the common trenches after forming a body region and source regions by injection.
FIG. 16 is a cross-sectional schematic diagram of second terminal trenches after forming the body region by injection.
FIG. 17 is a cross-sectional schematic diagram of the first narrow trenches after forming the body region by injection.
FIG. 18 is a cross-sectional schematic diagram of the common trenches after forming a dielectric layer and contact holes.
FIG. 19 is a cross-sectional schematic diagram of the second terminal trenches after forming the dielectric layer.
FIG. 20 is a cross-sectional schematic diagram of the first narrow trenches after forming the dielectric layer.

Reference numerals in the drawings: Epitaxial layer110; body region 120; source region 130; dielectric layer 140; contact hole 150; ohmic contact structure 151; metal layer 160; common MESA region 170; T-shaped region 171, 172, 173; outer terminal ring 210; intermediate terminal ring 220; inner terminal ring 230; first terminal trench 211, 221, 231; second terminal trenches 212, 222, 232; common trench 300; isolation oxide layer 201, 301, 311; source polysilicon structure 202, 302; filling oxide layer 303; gate polysilicon structure 304; gate oxide layer 305; shallow trench 306; first narrow trench 310; second narrow trench 320; third narrow trench 330.

### DETAILED DESCRIPTION

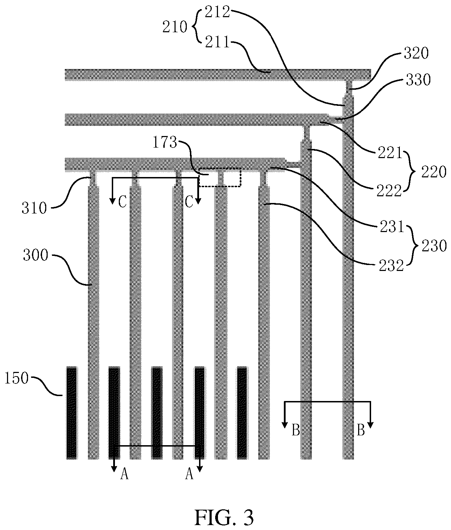

As shown in FIG. 3, FIG. 3 is a schematic diagram of a trench device terminal structure configured to improve electric field distribution uniformity according to one embodiment of the present disclosure.

The trench device terminal structure configured to improve electric field distribution uniformity comprises a substrate (not shown in the drawings). An epitaxial layer 110 is disposed on the substrate. Terminal trench rings are nested on the epitaxial layer 110. The terminal trench rings comprise an outer terminal ring 210, an inner terminal ring 230, and at least one intermediate terminal ring 220. The at least one intermediate terminal ring 220 is disposed between the outer terminal ring 210 and the inner terminal ring 230. Each of the terminal trench rings comprises two first terminal trenches disposed in parallel and two second terminal trenches disposed in parallel. The two second terminal trenches thereof are disposed between the two first terminal trenches thereof. The first terminal trenches are generally perpendicular to the second terminal trenches. A width of each of the first terminal trenches is equal to a width of each of the second terminal trenches. A depth of each of the first terminal trenches is equal to a depth of each of the second terminal trenches.

The embodiment is described by taking an example that the at least one intermediate terminal ring 220 comprises only one intermediate terminal ring 220 between the outer terminal ring 210 and the inner terminal ring 230. The outer terminal ring 210 includes two first terminal trenches 211 and two second terminal trenches 212, the intermediate terminal ring 220 includes two first terminal trenches 221 and two second terminal trenches 222, and the inner terminal ring 230 includes two first terminal trenches 231 and two second terminal trenches 232.

Common trenches 300 disposed at intervals are disposed in the inner terminal ring 230. The common trenches 300 are generally perpendicular to the first terminal trenches. A width of each of the common trenches 300 is not greater than the width of each of the first terminal trenches, and a depth of each of the common trenches 300 is not greater than the depth of each of the first terminal trenches. In the embodiment, the width and the depth of each of the common trenches 300 are equal to of the width and the depth of each of the first terminal trenches. Two ends of each of the common trenches 330 are respectively connected to the two first terminal trenches 231 of the inner terminal ring 230 through first narrow trenches 310. Two ends of each of the first terminal trenches of the inner terminal ring 230 and two ends of the first terminal trenches of the intermediate terminal ring 220 are respectively connected to the second terminal trenches of an outer one of the terminal trench rings through corresponding third narrow trenches 330. In the embodiment, the two ends of each of the first terminal trenches 231 of the inner terminal ring 230 are respectively connected to the two second terminal trenches 222 of the intermediate terminal ring 220 by two third narrow trenches 330, and the two ends of each of the first terminal trenches 22 of the intermediate terminal ring 220 are respectively connected to the second terminal trenches 212 of the outer terminal ring by two third narrow trenches 330,

A structure of each of the first narrow trenches 310, a structure of each of the second narrow trenches 320, and a structure of each of the third narrow trenches 330 may be the same. A width of each of the first narrow trenches 310, a width of each of the second narrow trenches 320, and a width of each of the third narrow trenches 330 are less than the width of each of the first terminal trenches. The first narrow trenches 310, the second narrow trenches 320, and the third narrow trenches 330 are generally formed by etching through a photolithography process, and depths of trenches formed by etching through the photolithography process is proportional to the widths. Therefore, a depth of each of the first narrow trenches 310, a depth of each of the second narrow trenches 320, and a depth of each of the third narrow trenches 330 are less than the depth of each of the first terminal trenches. Generally, the width of each of the first narrow trenches 310, the width of each of the second narrow trenches 320, and the width of each of the third narrow trenches 330 are not greater than two thirds of the width of each of the first terminal trenches. The width of each of the first narrow trenches 310, the width of each of the second narrow trenches 320, and the width of each of the third narrow trenches 330 are not less than one third of the width of each of the first terminal trenches.

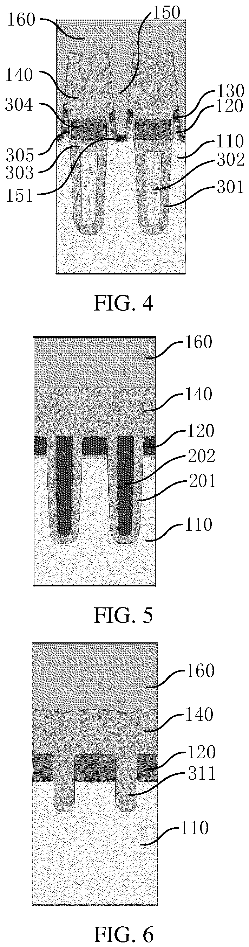

As shown in FIGS. 4-6, for a common trench MOS and a split gate trench MOS. isolation oxide layers 201 are respectively disposed on trench walls of the first terminal trenches and trench walls of the second terminal trenches. Source polysilicon structures 202 are respectively disposed in the first terminal trenches and the second terminal trenches. The trench walls of the first terminal trenches and the trench walls of the second terminal trenches are respectively isolated from the source polysilicon structures 202 through the isolation oxide layers 201. Isolation oxide layers 301 are respectively disposed on trench walls of the common trenches 300. Source polysilicon structures 302 are respectively disposed in the common trenches 300. The trench walls of the common trenches 300 are respectively isolated from the source polysilicon structures 302 through the isolation oxide layers 301. Gate polysilicon structures 304 are disposed over the source polysilicon structures 302, in the common trenches 300. A filling oxide layer 303 is disposed between each of the gate polysilicon structures 304 and each of the source polysilicon structures 302, so that the gate polysilicon structures 304 are respectively isolated from the source polysilicon structures 302. The gate polysilicon structures 304 are respectively isolated from the trench walls of the common trenches 300 through the gate oxide layers 305. Isolation oxide layers 311 are respectively disposed in the first narrow trenches 310, the second narrow trenches 320, and the third narrow trenches 330, The isolation oxide layer 311 are respectively flush with an edge of the narrow trenches (i.e., the first narrow trenches 310, the second narrow trenches 320, and the third narrow trenches 330). No polysilicon is disposed in the first narrow trenches 310, the second narrow trenches 320, and the third narrow trenches 330, so the source polysilicon structures 202 in the first terminal trenches 231 are respectively isolated from the source polysilicon structures 302 in the common trenches 300.

A body region 120 is formed on an upper portion of the epitaxial layer 110. Source regions 130 are respectively formed between each two adjacent common trenches 300 and upper portions of the body region 120, and each of the upper portions of the body region 120 is disposed between each of the second terminal trenches 232 of the inner terminal ring 230 and an adjacent common trench 300.

A dielectric layer 140 is disposed on the epitaxial layer 110, and the dielectric layer 140 defines contact holes 150. The contact holes 150 penetrate through the dielectric layer 140 and the source regions 130 and extend into the body region 120. The contact holes 150 are respectively located between each two adjacent common trenches 300 and between each of the second terminal trenches 232 of the inner terminal ring 230 and the adjacent common trench 300. An ohmic contact structure 151 is generally formed at a bottom portion of each of the contact holes 150. A metal layer 160 is disposed on the dielectric layer 140, and the metal layer 160 extends into the contact holes 150.

In a common terminal structure of a current trench MOS, a RESURF (surface electric field reduce) effect is more obvious in T-shaped regions 171 shown in FIG. 1 because each of the T-shaped regions 171 has an additional source polysilicon field plate (source polysilicon of the T-shaped regions 171 affects an electric field distribution in the vicinity thereof and acts as the field plate), so a junction electric field is lower. An electric field at bottom portion of the trenches shown in FIG. 1 is higher. One of consequences of a lower epitaxial concentration is a lower junction electric field. Therefore, when the terminal structure shown in FIG. 1 is of a relatively high epitaxial concentration, an avalanche voltage of the T-shaped regions 171 is inevitably and significantly lower than that of a cell region, which is prone to application failures and reliability test failures.

As shown in FIG. 2, T-shaped regions 172 of a terminal structure does not have trenches on two sides thereof like each Mesa region 170, but each only has a continuous trench on one side. Trenches on the other side of T-shaped regions 172 are periodically discontinuous, which results in a smaller capacitance per unit region of the T-shaped regions 172 under the same trench spacing. Further, less ions are formed in depletion regions at the same bias voltage when compared with other regions. Compared with the mesa regions 170, trench spacing of the T-shaped regions 172 needs to be reduced. The trench spacing of the T-shaped regions 172 is estimated from a perspective that impurity atoms need to be ionized into ions under a reverse bias state of the trench device, which is generally 50% to 60% of a spacing of final trenches (i.e., trenches on a wafer chip that manufactured by a split-gate trench (SGT) process; to distinguish them from semi-finished trenches) in a cell region. Since reduction of the trench spacing of the T-shaped regions 172 is limited by stress that a semiconductor material of the mesa regions 170 needs to withstand during a trench etching and oxidation process, while the T-shaped regions 172 are not allowed to cause cracking, collapse, and leakage, and a pitch (i.e., a width of a minimum repeating unit of the cell) of the trench MOS with a withstand voltage not greater than 30V and other low-voltage trench devices with low RSP is relatively small, the T-shaped regions 172 can hardly meet the requirements. In addition, one consequence of the reduction in the trench spacing of the T-shaped regions 172 is that the electric fields at bottom portions of the trenches of the T-shaped regions 172 (especially bottom portions of the trenches that are periodically discontinuous) are relatively high, which is easy to cause reliability problems and directly cause failure of BV (breakdown voltage) and Idss (leakage current in the static off state between the source and the drain) during CP testing (chip prober testing, which refers to a test performed on a chip after the chip is taped out, which is different from various tests after the chip is packaged), which increases the difficulty of process development.

The common trenches 300 in the T-shaped regions 171 are connected to the source polysilicon structures in the terminal trench rings shown in FIG. 1, while the source polysilicon structures 202 in the first terminal trenches 231 of the T-shaped regions 173 in the embodiment are respectively separated from the source polysilicon structures 302 in the common trenches 300 by the first narrow trenches 310 (without polysilicon), thereby overcoming shortcomings of the terminal structure shown in FIG. 1, making the trench electric field distribution of the T-shaped regions 173 in the embodiment closer to that of the cell region, making the electric field distribution in the entire MOS device more consistent, and improving the application performance and reliability of the MOS device under harsh working conditions.

Of course, the above embodiments take an example that the trench device is the trench MOS for illustration. The trench device terminal structure of the embodiment is not only applicable to the trench MOS, but also applicable to other trench devices such as deep trench diodes and even high-reliability trench process Insulated Gate Bipolar Transistors (IGBTs).

In the embodiment, the trenches of the T-shaped regions 173 of the trench device terminal structure are continuous, while the trenches on one side of the T-shaped regions 172 of the terminal structure in FIG. 2 are periodically discontinuous. In the embodiment, the spacing between the source polysilicon structures 302 in the common trenches 300 and the source polysilicon structures 202 in the first terminal trenches 231 are allowed to be smaller, so the trench device terminal structure is allowed to be applied to the trench device with a higher epitaxial concentration, and the trench device terminal structure is allowed to be applied to the trench device with a lower epitaxial concentration to enable the trench device to have a larger process window.

Compared with semiconductor material spacing between the mutually perpendicular trenches in the T-shaped regions 172 of the terminal structure in FIG. 2, the common trenches 300 and the first terminal trenches 231 in the T-shaped regions 173 of the embodiment are separated by the first narrow trenches 310 (the first oxide layers, such as SiO2, are respectively disposed in the first narrow trenches 310,, and the first narrow trenches 310 does not comprises the polysilicon) respectively, so that the electric fields at the bottom portions of the common trenches 300 and the bottom portions of the first terminal trenches 231 in the T-shaped regions 173 (especially the bottom portion of the end of the periodically discontinuous common trenches 300) is significantly reduced, which improves the application performance and reliability under harsh working conditions. In addition, compared with special regions of the arc-shaped trenches of the terminal trench rings in FIG. 2, corner regions of the terminal trench rings in the embodiment do not adopt arc-shaped structures, but are connected by the second narrow trenches 320 and the third narrow trenches 330, and the distribution thereof is more symmetrical and repetitive, therefore, the electric field distribution thereof is closer to the cell region. Thus, an epitaxial process window of the trench device is increased, the application performance and reliability under harsh working conditions are improved, and the difficulty of process research, the development and the debugging is reduced.

In addition, under a premise of ensuring reliability and RSP level of current silicon-based SGT devices, the terminal structure in FIG. 1 is only applicable to trench devices with a withstand voltage not greater than 30V, and the terminal structure in FIG. 2 is only applicable to trench devices with a withstand voltage greater than 30V, resulting in trench devices with a withstand voltage of 25-40V being unable to share a group of masks, or even if the trench devices with the withstand voltage of 25-40V are able to share a group of masks, the RSP level is reduced. For example, if the terminal structure in FIG. 2 is applied to the trench device with a withstand voltage not greater than 30V, the trench device is only applicable to an epitaxial wafer with a lower epitaxial concentration. The terminal structure in FIG. 1 is difficult to achieve a rated voltage not less than 40V. The trench device terminal structure of the embodiment has a larger epitaxial process window. After adopting the terminal structure of the embodiment, the trench devices with the withstand voltage of 25-40V are able to share the group of masks, and the loss of the RSP level is smaller.

Therefore, by adopting the trench device terminal structure, the electric field distribution in regions of the trench device terminal structure is made more consistent, application performance and reliability of the trench device terminal structure under harsh working conditions are improved, and the epitaxial process window of the trench device terminal structure is increased, thereby reducing the difficulty of process development and debugging.in addition, the trench device terminal structure is allowed to have a larger epitaxial process window, so the trench devices with the withstand voltage of 25-40V are able to share the same group of masks, so that loss of the RSP level is significantly less than that in the prior art.

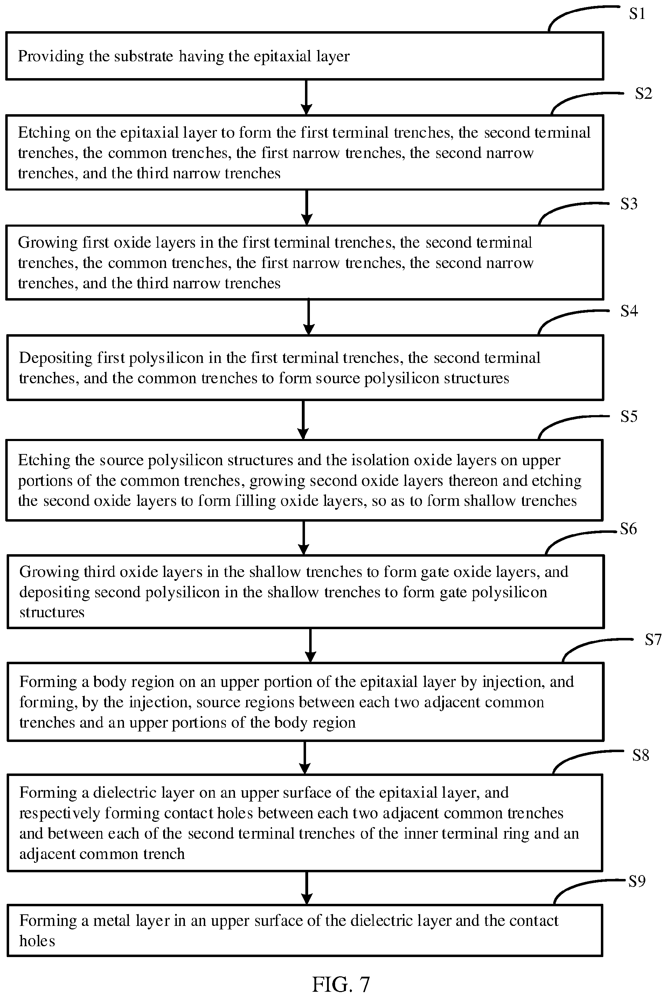

As shown in FIG. 7, FIG. 7 is a flow chart of a manufacturing method of the trench device terminal structure configured to improve electric field distribution uniformity according to one embodiment of the present disclosure. The manufacturing method of the trench device terminal structure configured to improve electric field distribution uniformity comprises steps S1-S9.

The step S1 comprises providing the substrate having the epitaxial layer 110.

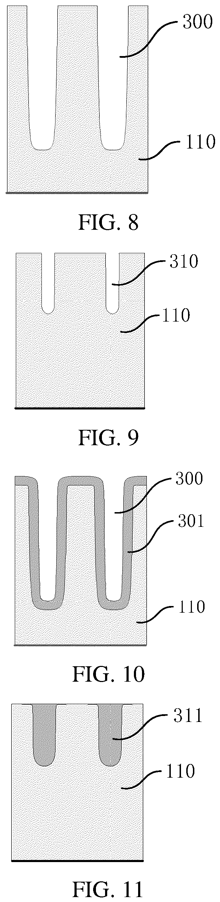

As shown in FIGS. 4, 8, and 9, the step S2 comprises etching on the epitaxial layer 110 to form the first terminal trenches, the second terminal trenches, the common trenches 300, the first narrow trenches 310, the second narrow trenches 320, and the third narrow trenches 330. In the embodiment, a structure of each of the first terminal trenches, a structure of each of the second terminal trenches, and a structure of each of the common trenches 300 are completely identical, and the structure of each of the first narrow trenches 310, the structure of each of the second narrow trenches 320, and the structure of each of the third narrow trenches 330 are completely identical. Therefore, the structures of each of the first terminal trenched and the structures of each of the second terminal trenches may refer to the structures of each of the common trenches 300 shown in FIG. 8, and the structures of each of the second narrow trenches 320 and the structures of each of the third narrow trenches 330 may refer to the first narrow trenches 310 shown in FIG. 9. As shown in FIG. 9, the width of each of the first narrow trenches 310, the width of each of the second narrow trenches 320, and the width of each of the third narrow trenches 330 are relatively narrow. The depth of each of the first narrow trenches 310, the depth of each of the second narrow trenches 320, and the depth of each of the third narrow trenches 330 are relatively shallow.

As shown in FIGS. 10-11, the step S3 comprises growing first oxide layers in the first terminal trenches, the second terminal trenches, the common trenches 300, the first narrow trenches 310, the second narrow trenches 320, and the third narrow trenches 330, so as to form the isolation oxide layers 201 in the trench walls of the first terminal trenches and the trench walls of the second terminal trenches, the isolation oxide layers 301 in the trench walls of the common trenches 300, the isolation oxide layers 311 in the first narrow trenches 310, the second narrow trenches 320 and the third narrow trenches 330.

Since the first narrow trenches 310, the second narrow trenches 320, and the third narrow trenches 330 have narrow widths and shallow depths, the first oxide layers are grown simultaneously in the first terminal trenches, the second terminal trenches, the common trenches 300, the first narrow trenches 310, the second narrow trenches 320, and the third narrow trenches 330. When the first oxide layers grown on the trench walls of the first terminal trenches, the trench walls of the second terminal trenches and the trench walls of the common trenches 300 reaches a predetermined thickness, the first oxide layer grown in the first narrow trenches 310, the second narrow trenches 320, and the third narrow trenches 330 just fill the narrow trenches. In addition, since the structure of each of the first terminal trenches, the structure of each of the second terminal trenches, and the structure of each of the common trenches 300 are exactly the same, after the step S3 is completed, shapes of the isolation oxide layers 201 in the first terminal trenches and the second terminal trenches may refer to the isolation oxide layers 301 shown in FIG. 10.

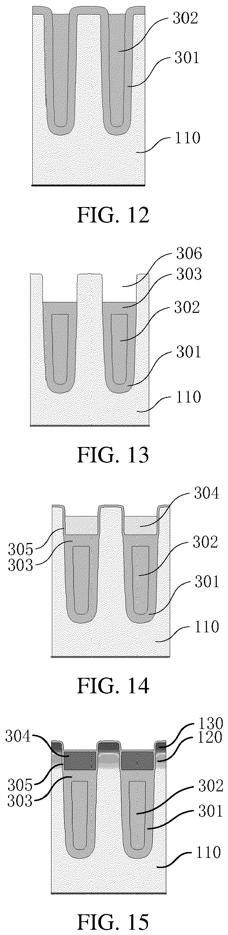

As shown in FIG. 12, the step S4 comprises depositing the polysilicon in the first terminal trenches and the second terminal trenches o form the source polysilicon structures 202, and depositing the polysilicon in the common trenches 300 to form the source polysilicon structures 302. A structure of each of the source polysilicon structures 202 may refer to a structure of each of the source polysilicon structures 302 shown in FIG. 12.

As shown in FIG. 13, the step S5 comprises etching the source polysilicon structures 302 and the isolation oxide layers 301on upper portions of the common trenches 300, growing second oxide layers thereon and etching the second oxide layers to form filling oxide layers 303, so as to form shallow trenches 306 at the upper portions of the common trenches 300. The filling oxide layers 303 are respectively configured to isolate the gate polysilicon structures 304 and the source polysilicon structures 302.

As shown in FIG. 14, the step S6 comprises growing third oxide layers in the shallow trenches 306 to form gate oxide layers 305, so that the gate polysilicon structures 304 are isolated from the trench walls of the common trenches 300; and depositing the polysilicon in the shallow trenches 306 to form the gate polysilicon structures 304.

As shown in FIGS. 15-17, the step S7 comprises forming the body region 120 on the upper portion of the epitaxial layer 110 by injection, and forming, by the injection, source regions 130 between each two adjacent common trenches 300 and the upper portions of the body region 120.

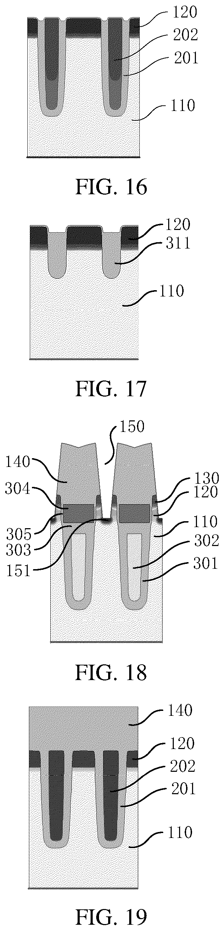

After this step S7 is completed, the structure each of the first terminal trenches may refer to the structure of each of the second terminal trenches shown in FIG. 16, and the structure of each of the second narrow trenches 320 and the structure of each of the third narrow trenches 330 may refer to the structure of each of the first narrow trenches 310 shown in FIG. 17.

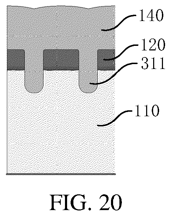

As shown in FIGS. 18-20, the step S8 comprises forming the dielectric layer 140 on an upper surface of the epitaxial layer 110, and respectively forming the contact holes 150 between each two adjacent common trenches 300 and between each of the second terminal trenches 232 of the inner terminal ring 230 and the adjacent common trench 300; wherein the contact holes 150 penetrate through the dielectric layer 140 and the source regions 130 and extend into the body region 120. In the step S8, an ohmic contact structure is generally formed at a bottom portion of each of the contact holes 150. After the step S8 is completed, the structure of each of the first terminal trenches may refer to the structure of each of the second terminal trenches shown in FIG. 19. The structure of each of the second narrow trenches 320 and the structure of each of the third narrow trenches 330 may refer to the structure of each of the first narrow trenches 310 shown in FIG. 20.

As shown in FIGS. 4-6, the step S9 comprises forming the metal layer 160 in the upper surface of the dielectric layer 140 and the contact holes 150.

In the trench device terminal structure manufactured by the manufacturing method, the electric field distribution in regions of the trench device terminal structure is made more consistent, application performance and reliability of the trench device terminal structure under harsh working conditions are improved, and the epitaxial process window of the trench device terminal structure is increased, thereby reducing the difficulty of process development and debugging.in addition, the trench device terminal structure is allowed to have a larger epitaxial process window, so the trench devices with the withstand voltage of 25-40V are able to share the same group of masks, so that loss of the RSP level is significantly less than that in the prior art.

## Claims

1. A trench device terminal structure configured to improve electric field distribution uniformity, comprising: a substrate;
wherein an epitaxial layer (110) is disposed on the substrate, terminal trench rings are disposed in the epitaxial layer (110), and the terminal trench rings comprise an outer terminal ring (210), an inner terminal ring (230), and at least one intermediate terminal ring (220); the at least one intermediate terminal ring (220) is disposed between the outer terminal ring (210) and the inner terminal ring (230);
wherein each of the terminal trench rings comprises two first terminal trenches (211, 221, 231) disposed in parallel and two second terminal trenches (212, 222, 232) disposed in parallel, and the two second terminal trenches thereof (212, 222, 232) are disposed between the two first terminal trenches (211, 221, 231) thereof;
wherein common trenches (300) disposed at intervals are disposed in the inner terminal ring (230), two ends of each of the common trenches (330) are respectively connected to the two first terminal trenches (231) of the inner terminal ring (230) through first narrow trenches (310); two ends of each of the second terminal trenches (212, 222, 232) are respectively connected to corresponding two first terminal trenches (211, 221, 231) through second narrow trenches (320), and two ends of each of the first terminal trenches (231) of the inner terminal ring (230) are respectively connected to the two second terminal trenches (212, 222, 232) of an adjacent intermediate terminal ring (220) of the at least one intermediate terminal ring (220) by corresponding third narrow trenches (330), two ends of each of the first terminal trenches ( 221) of the at least one intermediate terminal ring (220) are respectively connected to the second terminal trenches (222, 232) of an adjacent outer one of the terminal trench rings by corresponding third narrow trenches (330),
a width of each of the first narrow trenches (310), a width of each of the second narrow trenches (320), and a width of each of the third narrow trenches (330) are less than a width of each of the first terminal trenches (211, 221, 231).

2. The trench device terminal structure according to claim 1, wherein the width of each of the first terminal trenches (211, 221, 231) is equal to a width of each of the second terminal trenches (212, 222, 232);
wherein a width of each of the common trenches (300) is not greater than the width of each of the first terminal trenches (211, 221, 231);
wherein the width of each of the common trenches (300) is greater than the width of each of the first narrow trenches (310), the width of each of the second narrow trenches (320), and the width of each of the third narrow trenches (330).

3. The trench device terminal structure according to claim 2, wherein the width of each of the first narrow trenches (310), the width of each of the second narrow trenches (320), and the width of each of the third narrow trenches (330) are not greater than two thirds of the width of each of the first terminal trenches (211, 221, 231).

4. The trench device terminal structure according to claim 3, wherein the width of each of the first narrow trenches (310), the width of each of the second narrow trenches (320), and the width of each of the third narrow trenches (330) are not less than one third of the width of each of the first terminal trenches (211, 221, 231).

5. The trench device terminal structure according to claim 1, wherein the second terminal trenches (212, 222, 232) and the common trenches (300) are perpendicular to the first terminal trenches (211, 221, 231).

6. The trench device terminal structure according to claim 1, wherein a depth of each of the common trenches (300), and a depth of each of the first terminal trenches (211, 221, 231), and a depth of each of the second terminal trenches (212, 222, 232) are equal;
wherein a depth of each of the first narrow trenches (310), a depth of each of the second narrow trenches (320), and a depth of each of the third narrow trenches (330) are less than the depth of each of the common trenches (300).

7. The trench device terminal structure according to any one of claims 1-6, wherein isolation oxide layers (201, 301, 311) are respectively disposed on trench walls of the first terminal trenches (211, 221, 231), trench walls of the second terminal trenches (212, 222, 232), and trench walls of the common trenches (300) and are respectively disposed in the first narrow trenches (310), the second narrow trenches (320), and the third narrow trenches (330),
wherein source polysilicon structures (202, 302) are respectively disposed in the first terminal trenches (211, 221, 231), the second terminal trenches (212, 222, 232), and the common trenches (300);
wherein the trench walls of the first terminal trenches (211, 221, 231), the trench walls of the second terminal trenches (212, 222, 232), and the trench walls of the common trenches (300) are respectively isolated from the source polysilicon structures (202, 302) through the isolation oxide layers (201, 301, 311);
wherein gate polysilicon structures (304) are disposed over the source polysilicon structures (302) in the common trenches (300), a filling oxide layer (303) is disposed between each of the gate polysilicon structures (304) and each of the source polysilicon structures (202, 302), and the gate polysilicon structures (304) are respectively isolated from the trench walls of the common trenches (300) through the gate oxide layers (305).

8. The trench device terminal structure according to claim 7, wherein a body region (120) is formed on an upper portion of the epitaxial layer (110), source regions (130) are respectively formed between each two adjacent common trenches (300) and upper portions of the body region (120), and each of the upper portions of the body region (120) is disposed between each of the second terminal trenches (232) of the inner terminal ring (230) and an adjacent common trench (300);
wherein a dielectric layer (140) is disposed on the epitaxial layer (110), the dielectric layer (140) defines contact holes (150), the contact holes (150) penetrate through the dielectric layer (140) and the source regions (130) and extend into the body region (120), and the contact holes (150) are respectively located between each two adjacent common trenches (300) and between each of the second terminal trenches (232) of the inner terminal ring (230) and the adjacent common trench (300);
wherein a metal layer (160) is disposed on the dielectric layer (140), and the metal layer (160) extends into the contact holes (150).

9. A manufacturing method of the trench device terminal structure according to any one of claims 1-8, comprising:
a step S1: providing the substrate having the epitaxial layer (110);
a step S2: etching on the epitaxial layer (110) to form the first terminal trenches (211, 221, 231), the second terminal trenches (212, 222, 232), the common trenches (300), the first narrow trenches (310), the second narrow trenches (320), and the third narrow trenches (330);
a step S3: growing first oxide layers in the first terminal trenches (211, 221, 231), the second terminal trenches (212, 222, 232), the common trenches (300), the first narrow trenches (310), the second narrow trenches (320), and the third narrow trenches (330), so as to form the isolation oxide layers (201, 301, 311) in the trench walls of the first terminal trenches (211, 221, 231), the trench walls of the second terminal trenches (212, 222, 232), the trench walls of the common trenches (300) and in the first narrow trenches (310), the second narrow trenches (320), and the third narrow trenches (330);
a step S4: depositing polysilicon in the first terminal trenches (211, 221, 231), the second terminal trenches (212, 222, 232), and the common trenches (300) to form the source polysilicon structures (202, 302);
a step S5: etching the source polysilicon structures (202, 302) and the isolation oxide layers (201, 301, 311) on upper portions of the common trenches (300), growing second oxide layers thereon and etching the second oxide layers to form filling oxide layers (303), so as to form shallow trenches (306) at the upper portions of the common trenches (300);
a step S6: growing third oxide layers in the shallow trenches (306) to form gate oxide layers (305), and depositing the polysilicon in the shallow trenches (306) to form the gate polysilicon structures (304);
a step S7: forming the body region (120) on the upper portion of the epitaxial layer (110) by injection, and forming, by the injection, source regions (130) between each two adjacent common trenches (300) and the upper portions of the body region (120);
a step S8: forming the dielectric layer (140) on an upper surface of the epitaxial layer (110), and respectively forming the contact holes (150) between each two adjacent common trenches (300) and between each of the second terminal trenches (232) of the inner terminal ring (230) and the adjacent common trench (300); wherein the contact holes (150) penetrate through the dielectric layer (140) and the source regions (130) and extend into the body region (120); and
a step S9: forming the metal layer (160) in the upper surface of the dielectric layer (140) and the contact holes (150).

10. The manufacturing method according to claim 9, wherein in the step S3, the first oxide layers are synchronously grown in the first terminal trenches (211, 221, 231), the second terminal trenches (212, 222, 232), the common trenches (300), the first narrow trenches (310), the second narrow trenches (320) and the third narrow trenches (330); and when the first oxide layers grown on the trench walls of the first terminal trenches (211, 221, 231), the trench walls of the second terminal trenches (212, 222, 232), and the trench walls of the common trenches (300) reach a predetermined thickness, the first narrow trenches (310), the second narrow trenches (320), and the third narrow trenches (330) are respectively fully filled with the first oxide layers.
